## Europäisches Patentamt
## European Patent Office
## Office européen des brevets

(11) Veröffentlichungsnummer: **0 218 918**
**B1**

(12) **EUROPÄISCHE PATENTSCHRIFT**

(45) Veröffentlichungstag der Patentschrift:
29.11.89

(51) Int. Cl.⁴: **H03M 3/04, H04N 7/137**

(21) Anmeldenummer: **86112520.1**

(22) Anmeldetag: **10.09.86**

(54) **Codierer für mehrdimensionale Differenz-Pulscode-Modulation mit hoher Arbeitsgeschwindigkeit.**

(30) Priorität: **23.09.85 DE 3533868**

(43) Veröffentlichungstag der Anmeldung:
**22.04.87 Patentblatt 87/17**

(45) Bekanntmachung des Hinweises auf die Patenterteilung:
**29.11.89 Patentblatt 89/48**

(84) Benannte Vertragsstaaten:
**AT BE CH DE FR GB IT LI NL SE**

(73) Patentinhaber: **Siemens Aktiengesellschaft,
Wittelsbacherplatz 2, D-8000 München 2(DE)**

(72) Erfinder: **Grallert, Hans-Joachim, Dr.,
Tannenfleckstrasse 30, D-8038 Gröbenzell(DE)**
Erfinder: **Mattausch, Hans Jürgen, Dr., Am Brunnen 25,
D-8011 Kirchheim(DE)**

(56) Entgegenhaltungen:
**EP-A- 0 173 983
EP-A- 0 176 821
WO-A-80/00207
DE-A- 3 232 516
US-A- 4 075 655**

**IEEE INTERNATIONAL CONFERENCE ON
COMMUNICATIONS, 14.-17. Mai 1984, Amsterdam, NL,
Band 1, Seiten 250-255, IEEE, New York, US; S. DREWS
et al.: "Circuit technique for VLSI design of a video
codec" Seite 251, linke Spalte, letzter Absatz - rechte
Spalte, Zeilen 10,46-440-617-29 000**

## Beschreibung

Die Erfahrung betrifft einen Codierer für mehrdimensionale Differenz-Pulscode-Modulation mit hoher Arbeitsgeschwindigkeit.

Bei der digitalen Übertragung oder Speicherung von Signalen wird häufig das Differenz-Pulscode-Modulationsverfahren (DPCM) angewendet. Das ursprüngliche Signal wird zunächst in ein elektrisches Signal umgewandelt, abgetastet und anschließend digitalisiert. Anstelle der so gewonnenen digitalisierten Abtastwerte wird bei diesem Verfahren jeweils nur die Differenz des aktuellen Abtastwertes zu einem aus vorhergehenden Abtastwerten berechneten Schätzwertes übertragen. Ziel des Verfahrens ist es, weniger Daten übertragen bzw. speichern zu müssen.

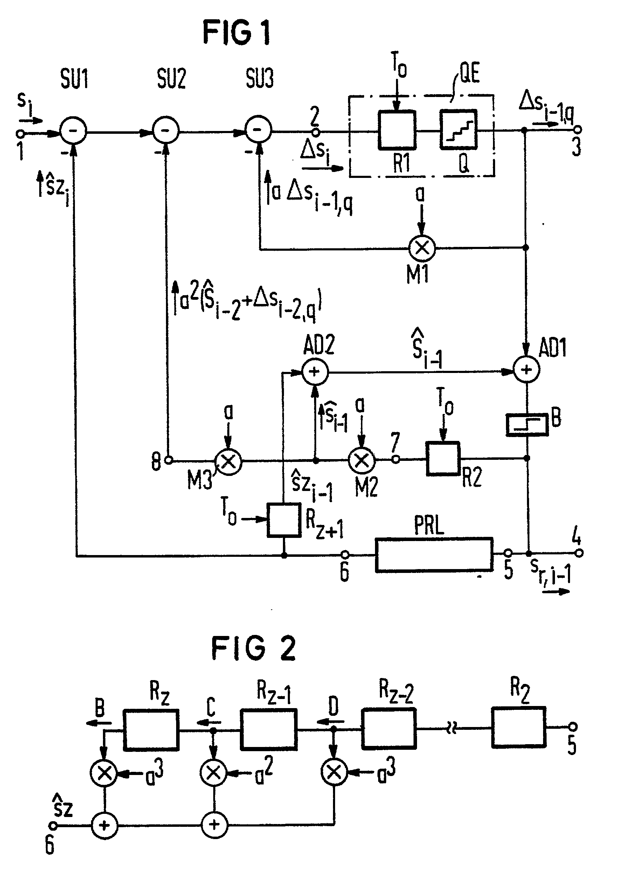

In der DE-A1 3 232 516 ist in der Figur 1 eine einfache DPCM-Schleife für eindimensionale Codierung dargestellt. Die Berechnung eines DPCM-Wertes erfolgt in vier Rechenschritten, die innerhalb des zeitlichen Abstandes zweier aufeinanderfolgender Abtastwerte durchgeführt werden müssen. Durch Verwendung eines speziellen Quantisierers nach Figur 2 der obengenannten Offenlegungsschrift wird ein Teil der Multiplikationen überflüssig und durch Aufteilung der Rechenoperationen auf drei verschiedene Rechenschleifen und die bisherige interne Rechenschleife ist es möglich, daß nur noch jeweils zwei Rechenschritte innerhalb des Abstandes zweier Abtastwerte durchgeführt werden müssen.

In der prioritätsälteren europäischen Patentanmeldung EP-A1 0 176 821, veröffentlicht am 9.4.86, ist ein DPCM-Codierer angegeben, der außer einer inneren Rechenschleife nur noch zwei weitere Rechenschleifen enthält. Die benötigten Multiplizierer können durch eine spezielle Verdrahtung realisiert werden, da sie die anliegenden Werte mit einem konstanten Prädiktionsfaktor $a = 2^{-n}$ ($n = 0,1,2 ...$) multiplizieren. Ein spezieller Quantisierer wie in der DE-A1 32 32 516 beschrieben, der an einem seiner Ausgänge einen mit dem Prädiktionsfaktor "a" multiplizierten DPCM-Wert abgibt, ist nicht erforderlich.

Der schematisch dargestellte Codierer eignet sich für eine eindimensionale DPCM-Codierung. Bei einer mehrdimensionalen Codierung, wie sie beispielsweise bei der Übertragung von Fernsehbildern erforderlich ist, ist ein weiterer Prädiktor erforderlich, der auch die Abtastpunkte einer vorangegangenen Fernsehzeile oder sogar des vorangegangenen Fernsehbildes bzw. Fernsehhalbbildes berücksichtigt.

Aufgabe der Erfindung ist es, einen schnellen Codierer für mehrdimensionale Differenz-Puls-Code-Modulation anzugeben.

Diese Aufgabe wird durch die im Patentanspruch 1 angegebenen Merkmale gelöst. Vorteilhafte Ausbildungen sind in den Unteransprüchen angegeben.

Erfindungsgemäß werden die erforderlichen Rechenoperationen parallel in drei Rechenschleifen durchgeführt. Während des Abstandes zweier Abtastwerte, kurz als Taktperiode eines Arbeitstaktes $T_0$ bezeichnet, müssen nur zwei Rechenoperationen durchgeführt werden. Ist es gestattet, drei Additionen oder Subtraktionen während einer Taktperiode durchzuführen, die Gesamtlaufzeit erhöht sich durch eine Reihenschaltung bekanntlich nur geringfügig, so vereinfacht sich die Schaltungsanordnung des Codierers.

Ausführungsbeispiele der Erfindung werden anhand von Figuren 1 bis 11 näher beschrieben.

Es zeigen

Fig. 1 ein Prinzipschaltbild des mehrdimensionalen Codierers,
Fig. 2 das Schaltbild eines Zeilenprädiktors,
Fig. 3 eine Variante des Zeilenprädiktors,
Fig. 4 eine Variante des Codierers,
Fig. 5 eine zweite Variante des Codierers,
Fig. 6 die Verwendung von Addierern zur Subtraktion,
Fig. 7 die Realisierung eines Multiplizierers,
Fig. 8 einen Begrenzer,
Fig. 9 einen Ausschnitt aus einen zu übertragenden Bild,
Fig. 10 ein Zeitdiagramm,
Fig. 11 eine Schaltungsvariante zur Subtraktion und
Fig. 12 eine weitere Variante des Codierers.

Das in Fig. 1 dargestellte Prinzipschaltbild eines mehrdimensionalen Codierers für Differenz-Pulscode-Modulation zeigt zwischen dem Codierereingang 1 und dem Codiererausgang 3 die Reihenschaltung von drei Subtrahierern SU1, SU2, SU3 mit einer Quantisiereinrichtung QE. Der Codierer enthält drei Rechenschleifen, die jeweils durch Rückführung von quantisierten DPCM-Werten vom Ausgang der Quantisiereinrichtung QE auf einen Subtraktionseingang der drei Subtrahierer SU1 bis SU3 gebildet werden.

Die erste Rechenschleife verläuft vom Ausgang 3 der Quantisiereinrichtung QE über einen ersten Multiplizierer M1 zum Subtraktionseingang des dritten Subtrahierers SU3, dessen Ausgang mit dem Eingang 2 der Quantisierereinrichtung QE verbunden ist.

Die zweite Rechenschleife verläuft vom Ausgang der Quantisiereinrichtung über einen ersten Addierer AD1, üblicherweise über einen Begrenzer B, dann über ein zweites Register R2 und zwei weitere Multiplizierer M2 und M3 zum Subtraktionseingang des zweiten Subtrahierers SU2. Die zweite Rechenschleife enthält eine innere Rechenschleife, die vom Ausgang des Begrenzers über das zweite Register R2, den zweiten Multiplizierer M2 und einen zweiten Addierer AD2 auf den zweiten Eingang des ersten Addierers AD1 zurückgeführt ist. Diese innere Rechenschleife kann mit vielen Schaltungsvarianten realisiert werden. Die Reihenfolge des zweiten Registers R2 und des zweiten Multiplizierers M2 ist natürlich vertauschbar. Ebenso kann das zweite Register unmittelbar dem zweiten Eingang des ersten Addierers AD1 vorgeschaltet werden oder der zweite Addierer AD2 dem ersten Eingang des ersten Addierers AD1 vorgeschaltet werden. Es kann unter Umständen auch auf den Begrenzer B verzichtet werden. In allen Fällen muß jedoch das am Ausgang des ersten Addierers AD1 anliegende Signal mit einem Faktor a multipliziert werden, bevor es dem zweiten Eingang des ersten Addierers um eine Taktperiode des Arbeitstaktes $T_0$ verzögert wieder zugeführt wird, und es muß mit dem Faktor $a^2$ multipliziert werden bevor es dem Subtraktionseingang des zweiten Subtrahierers SU2 zugeführt wird. Bei einer Variation der angegebenen Schaltung sind natürlich die Lauf- und Speicherzeiten der Bauelemente zu berücksichtigen.

Die dritte Rechenschleife verläuft vom Ausgang der Quantisiereinrichtung QE über den ersten Addierer AD1, den Begrenzer B, einen an den Ausgang 4 des Begrenzers B angeschlossenen Zeilenprädiktor PRL zum Subtraktionseingang des ersten Subtrahierers SU1. Außerdem ist der Ausgang 6 des Prädiktors PRL über ein weiteres Registers $R_{z+1}$ dem zweiten Eingang des zweiten Addierers AD2 verbunden.

Zunächst soll die Funktion des Codierers theoretisch betrachtet werden. Der Codierer soll an seinem Ausgang quantisierte DPCM-Werte $\Delta s_{i,q}$ liefern, die durch Quantisierung der errechneten DPCM-Signalwerte $\Delta s_i$ gewonnen werden, die am Eingang der Quantisiereinrichtung QE anliegen. Die dritte Rechenschleife und damit die mehrdimensionale Codierung soll zunächst unberücksichtigt bleiben. Die DPCM-Signalwerte $\Delta s_i$ werden durch Subtraktion eines sogenannten Schätzwertes

$$\hat{s}_i$$

von dem aktuellen Abtastwert $s_i$ gewonnen. Dies ist allgemein bekannt und kann den eingangs genannten Druckschriften entnommen werden.

$$(F1) \qquad \Delta s_i = s_i - \hat{s}_i,$$

wobei für die Berechnung des Schätzwertes $\hat{s}_i$ gilt

$$(F2) \qquad \hat{s}_i = a\,(\hat{s}_{i-1} + \Delta s_{i-1,q}),$$

$$(F3) \qquad \hat{s}_{i-1} = a\,(\hat{s}_{i-2} + \Delta s_{i-2,q})$$

mit (F3) in (F2) eingesetzt:

$$(F4) \qquad \hat{s}_i = a\left[a(\hat{s}_{i-2} + s_{i-2,q}) + s_{i-1,q}\right]$$

$$(F5) \qquad \hat{s}_i = a^2(\hat{s}_{i-2} + \Delta s_{i-2,q}) + a\,\Delta s_{i-1,q}$$

$$(F6) \qquad \hat{s}_i = a\,\hat{s}_{i-1} + a\,\Delta s_{i-1,q}$$

Der Vollständigkeit halber wird für den am lokalen Ausgang 4 abgegebenen rekonstruierten Wert angegeben:

$$(F7) \qquad s_{r,i} = \hat{s}_i + \Delta s_{i,q} = a\,(\hat{s}_{i-1} + \Delta s_{i-1,q}) + \Delta s_{i,q}$$

In dem DPCM-Codierer wird der Schätzwert $\hat{s}_i$ entsprechend F5 bzw. F6 berechnet. Für das DP-

3

CM-Signal ergibt sich somit

$$(F8) \qquad \Delta s_i = s_i - a \, \hat{s}_{i-1} - a \Delta s_{i-1,q}$$

Die Formel besagt, daß das aktuelle DPCM-Signal durch Subtraktion der angegebenen Terme vom aktuellen Abtastwert $s_i$ ermittelt wird.

Die angegebenen Formeln sind für eine eindimensionale DPCM-Codierung abgeleitet. Bei einer mehrdimensionalen (in den Ausführungsbeispielen zweidimensionalen) DPCM-Codierung gilt:

$$(F9) \qquad \hat{\hat{S}}_i = \hat{s}_i + \hat{s}z_i$$

Hierbei ist

$$\hat{s}_i$$

der Anteil des Schätzwertes, der dem Schätzwert bei einer eindimensionalen DPCM-Codierung entspricht und der zusätzliche Schätzwertanteil

$$\hat{s}z_i$$

der Anteil des Schätzwertes einer mehr als eindimensionalen DPCM-Codierung.

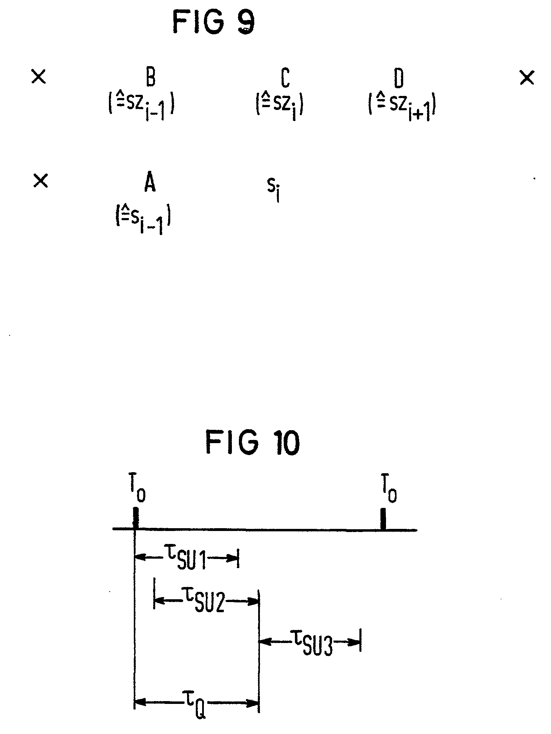

Anhand Fig. 9 soll dies näher erläutert werden. In ihr ist ein Ausschnitt aus einem Fernsehbild - zwei übereinanderliegende Fernsehzeilen - dargestellt. Bei der mehrdimensionalen DPCM-Codierung wird der Schätzwert nicht nur aus dem dem aktuellen Abtastwert $s_i$ vorangegangenen Abtastwert A ermittelt, sondern beispielsweise auch aus den darüberliegenden Abtastwerten B, C und D der vorangegangenen Zeile. Der Schätzwert wird beispielsweise nach Formel

$$(F10) \qquad \hat{S}_i = aA + a^3B + a^2C + a^3D$$

errechnet. Hier wurde angenommen, daß die Faktoren, mit denen die einzelnen Abtastwerte gewichtet werden, Potenzen von a sind. Im Codierer wird der Schätzwert, wie allgemein bekannt ist, natürlich nicht aus den Abtastwerten direkt, sondern aus den am lokalen Ausgang 4 des Codierers anliegenden rekonstruierten Abtastwerten errechnet, um einen Gleichlauf mit den Decodierer auf der Empfangsseite zu gewährleisten. In Fig. 9 wurde außerdem die Zuordnung der Bildpunkte A, B, C und D zu den mit Indizes bezeichneten Abtastwerten s dargestellt. Zu jedem Abtastwert $s_i$ muß ein entsprechender Schätzwert

$$\hat{s}_i$$

errechnet werden. Entsprechend Formel (F2) gilt:

$$(F11) \qquad \hat{s}_i = aA = a(\hat{\hat{S}}_{i-1} + \Delta s_{i-1,q})$$

Folglich für den zusätzlichen Schätzwertanteil:

$$(F12) \qquad \hat{s}z_i = a^3B + a^2C + a^3D$$

und somit:

$$(F13) \qquad \hat{\hat{S}}_i = a(\hat{\hat{S}}_{i-1} + \Delta s_{i-1,q}) + \hat{s}z_i$$

Bevor die Funktion des Codierers näher erläutert wird, sollen zunächst noch einige Voraussetzungen gemacht werden. In der Schaltungsanordnung nach Fig. 1 sind Register R als Speicher vorgesehen. Ein solches Register R1 ist in der Quantisiereinheit QE enthalten und ein zweites Register R2 ist den Begrenzer B nachgeschaltet. Ein zusätzliches Register $R_{z+1}$ ist dem zweiten Eingang des zweiten Addierers AD2 vorgeschaltet und weitere Register befinden sich im Prädiktor PRL. Mit einem Taktimpuls $T_0$ werden die Register gesteuert. Eine Taktperiode des Taktimpulses $T_0$ entspricht dem zeitlichen Abstand zweier Abtastwerte $s_i$ und $s_{i+1}$. Es ist selbstverständlich, daß anstelle der Register Laufzeitglieder oder andere Speicher verwendet werden können. Die Multiplizierer M weisen keine oder nur eine vernachlässigbare Laufzeit auf, da sie durch eine entsprechende Verdrahtung realisierbar sind. Dies setzt voraus, daß der Prädiktionsfaktor a = 1/2 oder eine Potenz hiervon ist. Die angegebenen Signalbezeichnungen gelten für einen Zeitpunkt unmittelbar vor einem Taktimpuls $T_0$.

Der Codierer soll zunächst unter Vernachlässigung der dritten Rechenschleife und somit des ersten Subtrahierers SU1 erläutert werden. Hierzu wird von einem gegenüber der Darstellung nach Fig. 1 zurückliegenden Zeitpunkt ausgegangen. Von dem am Codierereingang 1 anliegenden Abtastwert $s_i$ wird im zweiten Subtrahierer (SU2) der Term

$$a\hat{s}_{i-1}$$

subtrahiert und im dritten Subtrahierer der Term $a\Delta s_{i-1,q}$. Der erste Term wurde entsprechend Formel (F3) für die inneren Rechenschleife gewonnen. Entsprechend (F2) wurde somit vom Abtastwert $s_i$ der Schätzwert

$$\hat{s}_i$$

für eindimensionale Codierung subtrahiert.

In der dritten Rechenschleife wird der zusätzliche Schätzwertanteil

$$\hat{s}z$$

bei einer mehrdimensionalen DPCM-Codierung ermittelt. Über das Register $R_{z+1}$ wird dieser Schätzwertanteil

$$\hat{s}z_{i-1}$$

dem zweiten Addierer AD2 zugeführt, zu dem Schätzwert

$$\hat{s}z_{i-1}$$

(F3) aus der inneren Rechenschleife addiert und dem zweiten Eingang des ersten Addierers AD1 zugeführt. Vom Ausgang 6 des Prädiktors PRL wird der zusätzliche Schätzwertanteil

$$\hat{s}z$$

dem Subtraktionseingang des ersten Subtrahierers SU1 zugeführt. Unter Verwendung der Formeln (F13), (F11) und (F5) ergibt sich damit für einen DPCM-Signalwert $\Delta s_i$:

$$(F14) \qquad \Delta s_i = s_i - \hat{s}z_i - a^2(\hat{s}_{i-2} + \Delta s_{i-2,q}) - a\Delta s_{i-1,q}$$

Die Rechenschleifen sind so aufgebaut, daß die Rechenoperationen in den verschiedenen Rechenschleifen gleichzeitig erfolgen. In der ersten Rechenschleife befindet sich das Register R1 der Quantisierer Q, ein praktisch laufzeitfreier Multiplizierer M1 und der dritte Subtrahierer SU3. In dieser Rechenschleife muß die Information des Registers R1 ausgelesen werden und es müssen zwei Rechenschritte, nämlich eine Quantisierung und eine Subtraktion erfolgen. Während jedoch die Quantisierung erfolgt, werden bereits Subtraktionen in den Subtrahierern SU1 und SU2 durchgeführt, so daß die voneinander zu subtrahierenden Signale ca. gleichzeitig an den Eingängen des dritten Subtrahierers SU3 anliegen. Durch die Serienschaltung von mehreren Subtrahierern wird die Gesamtlaufzeit bekanntlich nur geringfügig verlängert, da jeweils bereits das Ergebnis der niederwertigsten Binärstelle genügt, um einen korrekten Subtraktionsvorgang beim nachfolgenden Subtrahierer zu beginnen. Dies ist im Zeitdiagramm nach Fig. 10 dargestellt, in dem die Laufzeit $\tau_Q$ des Quantisierers ca. der Summe der Laufzeiten $\tau_{SU1}$ und $\tau_{SU2}$ der zwei Subtrahierer SU1 und SU2 entspricht. Auch in der inneren Rechenschleife müssen während einer Taktperiode nur zwei Additionen durchgeführt werden. Bei den zur Zeit üblichen Laufzeiten von Subtrahierern und Quantisiereinrichtungen kann davon ausgegangen werden, daß die Laufzeit der ersten Rechenschleife praktisch die Summe der Laufzeit $\tau_Q$ der Quantisiereinrichtung QE und der Laufzeit $\tau_{SU3}$ des dritten Subtrahierers SU3 die maximale Arbeitsgeschwindigkeit des Codierers bestimmt. Die Laufzeit der Register ist vernachlässigbar klein.

In Fig. 2 ist der Zeilenprädiktor PRL genauer dargestellt. Er enthält hier Register $R_2$ bis $R_z$ als Laufzeitglieder, die ebenfalls vom Taktimpuls $T_0$ angesteuert werden und das Eingangssignal $s_{r,i-1}$ nahezu um die Dauer einer Fernsehzeile verzögern. An die Ausgänge der drei letzten Kippstufen $R_{z-2}$, $R_{z-1}$ und $R_z$ ist jeweils ein Multiplizierer angeschaltet. Die Ausgänge der Multiplizierer werden über Addierer zusammengefaßt und am Ausgang 6 des Prädiktors wird der zusätzliche Schätzwertanteil

$$\hat{s}z$$

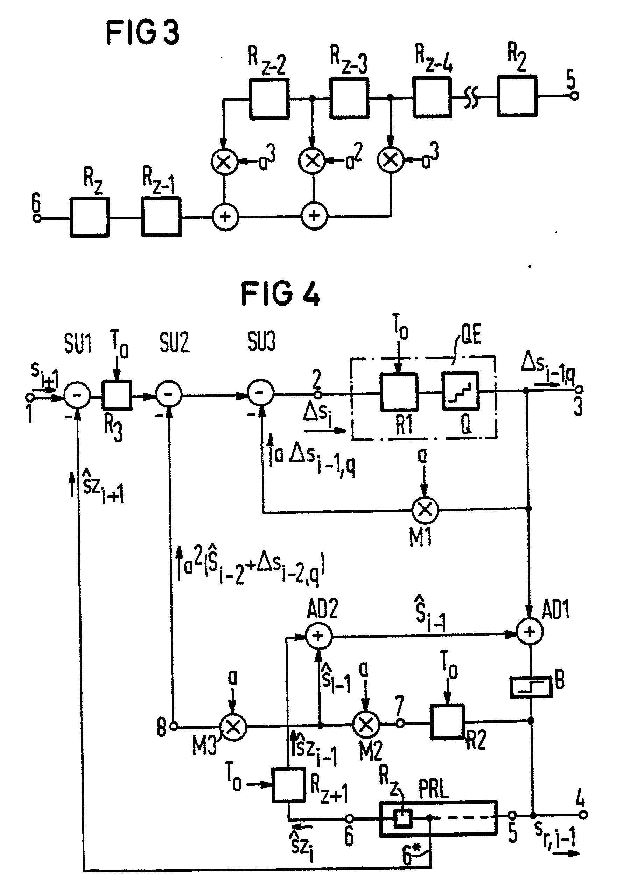

abgegeben. Um Laufzeitprobleme zu vermeiden wird der Zeilenprädiktor üblicherweise entsprechend Fig. 3 aufgebaut. Bei diesem Prädiktor wird der zusätzliche Schätzwert bereits um zwei Taktperioden früher ermittelt und durch die letzten beiden Register $R_{z-1}$ und $R_z$ verzögert. Der zusätzliche Schätzwertanteil

$$\hat{s}z$$

kann auch bereits noch früher ermittelt werden.

Ebenso kann dieser Schätzwertanteil auch bei einer dreidimensionalen DPCM-Codierung die Abtastwerte des vorangegangenen Fernsehbildes berücksichtigen.

In Fig. 4 ist eine Variante des Codierers dargestellt. Zwischen dem ersten Subtrahierer SU1 und dem zweiten Subtrahierer SU2 ist ein drittes Register R3 eingeschaltet. Entsprechend wird dem Subtraktionseingang des ersten Subtrahierers SU1 ein um einen Taktperiode jüngerer zusätzlicher Schätzwertanteil

$$\hat{s}z_{i+1}$$

zugeführt, der vom Eingang des letzten Registers $R_z$ des Prädiktors PRL abgenommen wird. Durch diese Maßnahme kann bei einem entsprechend schnellen Quantisierer Q die Arbeitsgeschwindigkeit des Codierers geringfügig erhöht werden, da nur zwei Subtrahierer SU2 und SU3 in Serie geschaltet sind. Als Quantisierer Q kann ein ROM oder ein Gatternetzwerk (logic array) verwendet werden.

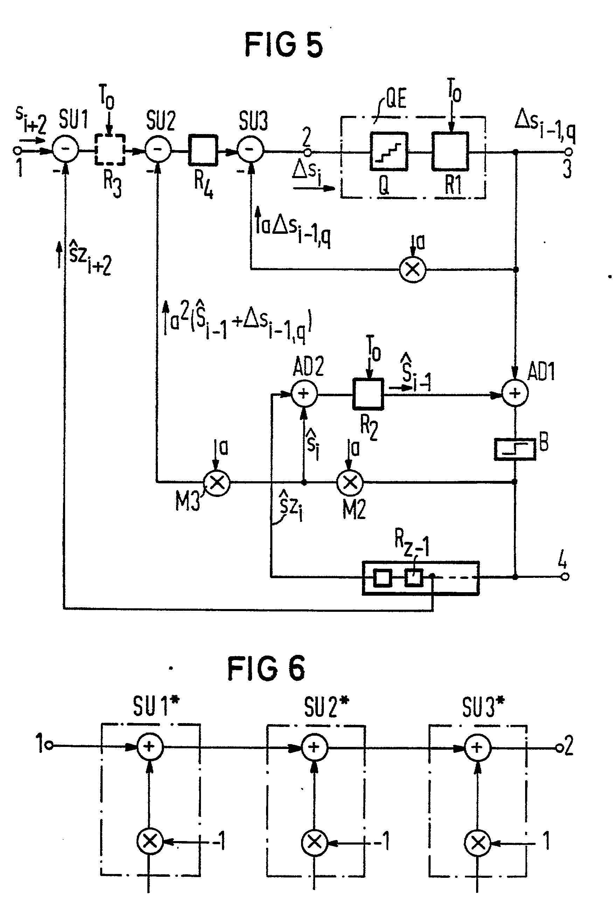

In Fig. 5 ist eine weitere Variante des Codierers dargestellt, bei der das zweite Register R2 direkt dem zweiten Eingang des ersten Addierers AD1 vorgeschaltet ist. Hierdurch wird es möglich, ein viertes Register R4 zwischen den Subtrahierern SU2 und SU3 einzuschalten. Bei der Quantisiereinrichtung QE wird die Reihenfolge von Quantisierer Q und erstem Register R1 umgedreht. In jeder Rechenschleife sind hierdurch während einer Taktperiode nur zwei Rechenoperationen erforderlich. Das dritte Register R3 kann bei Bedarf - in Fig. 5 dargestellt - eingefügt bleiben.

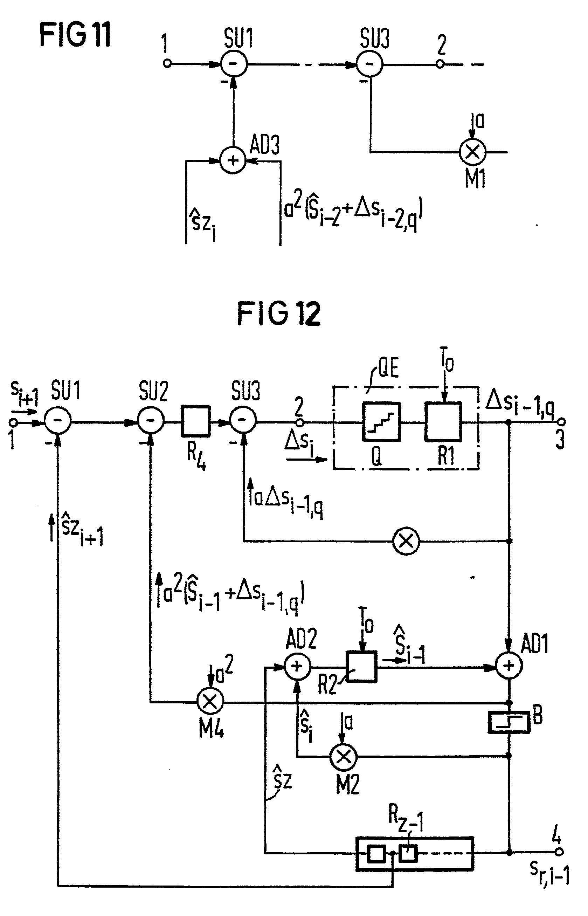

Falls die Laufzeit des Begrenzers B stören sollte, kann der Subtraktionseingang des zweiten Subtrahierers SU2 über einen mit dem Faktor $a^2$ arbeitenden Multiplizierer M4 direkt mit dem Ausgang des ersten Addierers AD1 verbunden werden. Diese Variante ist in Fig. 12 dargestellt. Im übrigen entspricht diese Variante der in Fig. 5 dargestellten Schaltungsanordnung.

Die Funktion dieses Codierers entspricht der Funktion der bereits beschriebenen. Trotzdem soll die Ermittlung der DPCM-Signalwerte $\Delta s_i$ kurz nachvollzogen werden. Die angegebenen Signale gelten wieder für einen Zeitpunkt kurz vor einem Taktimpuls $T_0$. Vor zwei Taktperioden lag an den Eingang 1 der Abtastwert $s_i$ an. Von diesem wurde zunächst der zusätzliche Schätzwertanteil

$$\hat{s}z_i$$

subtrahiert. Nach einer weiteren Taktperiode lag am Eingang 1 der Abtastwert $s_{i+1}$ an und am Ausgang des dritten Registers R3 die Differenz

$$s_i - \hat{s}z_i$$

von der entsprechend der Formel (F5) zunächst der Term

$$a^2(\hat{s}_{i-2} + \Delta s_{i-2,q})$$

subtrahiert wird.

Nach einer weiteren Taktperiode ergeben sich die angegebenen Signalwerte. Entsprechend Formel 14 liegt am Eingang der Quantisierungseinrichtung QE der gewünschte DPCM-Signalwert $\Delta$ $s_i$. Wie aus den vorangegangenen Schaltungsbeschreibungen entnehmbar ist, kann das Register R3 entfallen. Der erste Subtrahierer SU1 kann auch zwischen dem Ausgang des vierten Registers (R4) und dem dritten Subtrahierer SU3 eingeschaltet werden. Selbstverständlich muß dann der jeweils zugehörige zusätzliche Schätzwert - entsprechend Fig. 4 bzw. Fig. 1 - dem Subtraktionseingang (-) des ersten Subtrahierers zugeführt werden.

Anstelle der Subtrahierer können auch Addierer verwendet werden, denen das Zweierkomplement zugeführt wird. In Fig. 6 ist dies schematisch dargestellt. Die hier verwendeten drei Subtrahierer SU1*, SU2* und SU3* bestehen jeweils aus einem Addierer, dem ein Multiplizierer vorgeschaltet ist, der die zu subtrahierenden Werte mit dem Faktor -1 multipliziert. Ein sowohl als Addierer als auch als Subtrahierer verwendbarer Baustein ist der Typ SN 54 181 der Firma Texas Instruments.

In Fig. 11 ist eine Variante zur Verwendung der drei in Reihe geschalteten Subtrahierer SU1 bis SU3 dargestellt.

Der zweite Subtrahierer ist entfallen; dafür wurde ein dritter Addierer AD3 vorgesehen, dessen Ausgang mit dem Subtraktionseingang (-) des ersten Subtrahierers SU1 verbunden ist. An den Eingängen des dritten Addierers liegen die Signale an, die bisher den Subtraktionseingängen des ersten und zweiten Subtrahierers zugeführt wurden.

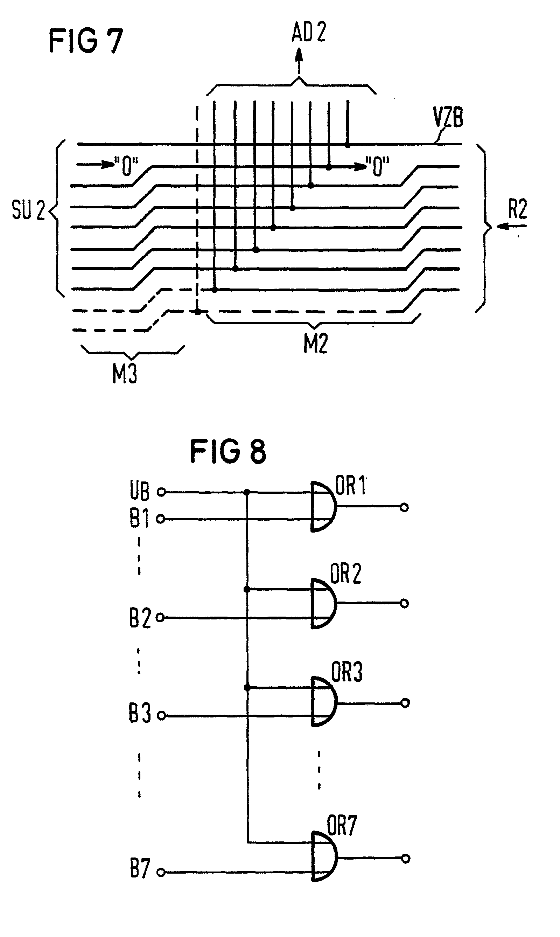

In Fig. 7 ist die Realisierung der Multiplizierer M2 und M3 durch eine spezielle Verdrahtung schematisch dargestellt. In diesem Beispiel soll mit dem Faktor 1/2 multipliziert werden. Der zweite Multiplizierer M2 wird dadurch realisiert, daß alle Bits bis auf das Vorzeichen Bit VZB um eine Binärstelle verschoben werden und als nach dem Vorzeichenbit VZB höchstwertiges Bit eine binäre "Null" eingesetzt wird. Dieser Vorgang wiederholt sich nochmals bei dem dritten Multiplizierer M3. Die genaue Ausführung des Multiplizierers ist davon abhängig, ob der Binary-Offset-Code oder der Zweierkomplement-Code verwendet wird. Die Bezeichnungen an den Leitungen weisen auf die an die Multiplizierer angeschlossenen Bauelemente hin. Sollen die sogenannten Nachkommastellen voll mitberücksichtigt werden, so sind die strichliert gezeichneten Leitungen mit zu verwenden.

Es kann selbstverständlich auch eine aus der DE-OS 23 32 516 bekannte Quantisierungseinrichtung verwendet werden, die den Multiplizierer M1 überflüssig macht. Diese aufwendigere Quantisiereinrichtung ist bei Prädiktionsfaktoren

$$a \neq 2^{-n}$$

zweckmäßig.

In Fig. 8 ist das Prinzipschaltbild eines Begrenzers für positive Zahlen dargestellt. Die Begrenzung soll ab einem Zahlenwert $2^7 - 1$ erfolgen. Der Begrenzer besteht aus 7 OR-Gattern OR1 bis OR7, deren Eingänge jeweils eines von 7 Bits B1 bis B7 zugeführt werden. Wird dieser Zahlenbereich überschritten, um dies festzustellen, muß mit einer Binärstelle mehr gerechnet werden, wird ein Überlaufbit UB den Zustand der logischen Eins annehmen und unabhängig von den Werten aller übrigen Bits alle Gatterausgänge auf die logische Eins schalten, wodurch der Zahlenwert $2^7 - 1$ dargestellt wird. Genaue Schaltungsanordnungen von Multiplizierern und Begrenzern nach den hier aufgezeigten Prinzipien sind dem Fachmann bekannt und brauchen hier nicht weiter erörtert werden.

## Patentansprüche

1. Codierer für mehrdimensionale Differenz-Pulscode-Modulation (DPCM) mit hoher Arbeitsgeschwindigkeit, gekennzeichnet durch:

a) eine Quantisierungseinrichtung (QE), der eine Reihenschaltung eines ersten, zweiten und dritten Subtrahierers (SU1, SU2, SU3) vorgeschaltet ist, wobei dem ersten Subtrahieren (SU1) vom Eingang (1) des Codierers digitalisierte Abtastwerte (si) zugeführt werden,

b) eine erste Rechenschleife, die vom Ausgang (3) der Quantisierungseinrichtung (QE), an dem quantisierte DPCM-Werte ($\Delta$si, q) abgegeben werden, über einen ersten Multiplizierer (M1), der mit einem konstanten Prädiktionsfaktor (a) multipliziert, auf den Subtraktionseingang (-) des der Quantisiereinrichtung (QE) direkt vorgeschalteten dritten Subtrahierers (SU3) rückgeführt ist.

c) eine innere Rechenschleife, die einen an den Ausgang (3) der Quantisiereinrichtung angeschalteten ersten Addierer (AD1) aufweist, dessen Ausgang über die Reihenschaltung eines zweiten Registers (R2) und eines zweiten Multiplizierers (M2) sowie über einen zweiten Addierer (AD2) auf den zweiten Eingang des ersten Addierers (AD1) rückgeführt ist,

d) eine zweite Rechenschleife, die vom Ausgang (3) der Quantisiereinrichtung (QE) über den ersten Addierer (AD1), das zweite Register (R2) und über zwei jeweils mit dem Prädiktionsfaktor (a) multiplizierende Multiplizierer (M2, M3) auf den Subtraktionseingang (-) des dem dritten Subtrahierer (SU3) vorgeschalteten zweiten Subtrahierers (SU2) rückgeführt ist und

e) eine dritte Rechenschleife, die über den ersten Addierer (AD1) und einen Zeilenprädiktor (PRL), der an seinem Ausgang (6) einen zusätzlichen Schätzwert

$$(\hat{s}zi)$$

abgibt, auf den Subtraktionseingang (–) des ersten Subtrahierers (SU1) rückgeführt ist, wobei der Ausgang (6) des Zeilenprädiktors (PRL) außerdem über ein Register ($R_{z+1}$) auf den zweiten Eingang des zweiten Addierers (AD2) in der inneren Rechenschleife geführt ist.

2. Codierer nach Anspruch 1, dadurch gekennzeichnet, daß zwischen dem ersten Subtrahierer (SU1) anstatt mit dem Ausgang (6) und dem zweiten Subtrahierer (SU2) ein drittes Register (R3) eingeschaltet ist und daß der Subtraktionseingang (–) des ersten Subtrahierers (SU1) mit einem zweiten Ausgang (6*) des Zeilenprädiktors (PRL), an dem zusätzliche Schätzwert

$$(\overset{\wedge}{\hat{s}}z_i)$$

bereits früher als am Ausgang (6) anliegt, verbunden ist (Fig. 4).

3. Codierer nach Anspruch 1 oder 2, dadurch gekennzeichnet, daß die Quantisierereinrichtung (QE) ein erstes Register (R1) mit einem nachgeschalteten Quantisierer (Q) oder umgekehrt enthält.

4. Codierer nach Anspruch 1 oder 2, dadurch gekennzeichnet, daß zwischem dem zweiten Subtrahierer (SU2) und dem dritten Subtrahierer (SU3) ein viertes Register (R4) eingeschaltet ist, daß das zweite Register (R2) dem zweiten Eingang des ersten Addierers (AD1) direkt vorgeschaltet ist,
daß der Ausgang des zweiten Addierers mit dem Eingang des zweiten Registers (R2) verbunden ist und daß die Quantisierereinheit (QE) einen Quantisierer (Q) mit einem nachgeschalteten ersten Register (R1) enthält (Fig. 5).

5. Codierer nach einem der vorhergehenden Ansprüche, dadurch gekennzeichnet, daß dem ersten Addierer (AD1) ein Begrenzer (B) nachgeschaltet ist.

6. Codierer nach einem der vorhergehenden Ansprüche, dadurch gekennzeichnet, daß anstelle der Subtrahierer (SU1 bis SU3) Addierer vorgesehen sind, denen die zu subtrahierenden Rechenwerte mit dem Faktor -1 multipliziert zugeführt werden.

7. Codierer nach einem der vorhergehenden Ansprüche, dadurch gekennzeichnet, daß nur Prädiktionsfaktoren $a = 2_{-n}$ (n = 0,1,2,3,...) vorgesehen sind und die Multiplizierer (M) durch eine entsprechende Verdrahtung realisiert sind.

8. Codierer nach Anspruch 1, dadurch gekennzeichnet, daß statt der Register (R) Laufzeitglieder vorgesehen sind.

9. Codierer nach Anspruch 1 oder Anspruch 3, dadurch gekennzeichnet, daß statt des zweiten Subtrahierers (SU2) ein dritter Addierer (AD3) vorgesehen ist, dessen Eingänge mit den Ausgängen des dritten Multiplizierers (M3) und des Prädiktors (PRL) verbunden sind und dessen Ausgang mit dem Subtraktionseingang des ersten Subtrahierers (SU1) verbunden ist.

10. Codierer nach Anspruch 4, dadurch gekennzeichnet, daß der Ausgang des ersten addierers (AD1) über einen mit dem Quadrat des Prädiktionsfaktors ($a^2$) multiplizierenden vierten Multiplizierers (MU) mit den Subtraktionseingang (-) des zweiten Subtrahierers (SU2) verbunden ist.

## Claims

1. Multi-dimensional DPCM coder with a high processing speed, characterised by:
a) A quantisation device (QE) which is preceded by a series circuit of a first, second and third subtracting unit (SU1, SU2, SU3), the first subtracting unit (SU1) being supplied with digitised samples (si) from the input (1) of the coder,
b) A first computing loop which is fed back from the output (3) of the quantisation device (QE), at which quantised DPCM values ($\Delta si$, q) are output, via a first multiplier (M1) which multiplies by a constant prediction factor (a), to the subtraction input (–) of the third subtracting unit (SU3) which directly precedes the quantisation device (QE).
c) An inner computing loop which exhibits a first adder (AD1), which is connected to the output (3) of the quantisation device and the output of which is fed back via the series circuit of a second register (R2) and a second multiplier (M2) and via a second adder (AD2) to the second input of the first adder (AD1),
d) A second computing loop which is fed back from the output (3) of the quantisation device (QE) via the first adder (AD1), the second register (R2) and via two multipliers (M2, M3), which in each case multiply by the prediction factor (a), to the subtraction input (–) of the second subtracting unit (SU2) preceding the third subtracting unit (SU3), and
e) A third computing loop which is fed back via the first adder (AD1) and a line predictor (PRL) which delivers at its output (6) an additional estimated value

$$(\hat{S}zi)$$

to the subtraction input (–) of the first subtracting unit (SU1), the output (6) of the line predictor (PRL) also being connected via a register ($R_{z+1}$) to the second input of the second adder (AD2) in the inner computing loop.

2. Coder according to Claim 1, characterised in that a third register (R3) is inserted between the first subtracting unit (SU1) and the second subtracting unit (SU2) and that the subtraction input (–) of the first subtracting unit (SU1) is connected to, instead of the output (6), a second output (6*) of the line predictor (PRL) at which the additional estimated value

$$(\hat{S}z_i)$$

is already present earlier than at the output (6) (Fig. 4).

3. Coder according to Claim 1 or 2, characterised in that the quantisation device (QE) contains a first register (R1) with a subsequent quantiser (Q) or the reverse arrangement.

4. Coder according to Claim 1 or 2, characterised in that a fourth register (R4) is inserted between the second subtracting unit (SU2) and the third subtracting unit (SU3), that the second register (R2) directly precedes the second input of the first adder (AD1), that the output of the second adder is connected to the input of the second register (R2), and that the quantisation unit (QE) contains a quantiser (Q) with a subsequent first register (R1) (Fig. 5).

5. Coder according to one of the preceding claims, characterised in that the first adder (AD1) is followed by a limiter (B).

6. Coder according to one of the preceding claims, characterised in that, instead of the subtracting units (SU1 to SU3), adders are provided which are supplied with the mathematical values to be subtracted, multiplied by a factor of –1.

7. Coder according to one of the preceding claims, characterised in that only prediction factors a = $2^{-n}$ (n = 0, 1, 2, 3, ...) are provided and the multipliers (M) are implemented by appropriate wiring.

8. Coder according to Claim 1, characterised in that delay sections are provided instead of the register (R).

9. Coder according to Claim 1 or Claim 3, characterised in that, instead of the second subtracting unit (SU2), a third adder (AD3) is provided the inputs of which are connected to the outputs of the third multiplier (M3) and of the predictor (PRL) and the output of which is connected to the subtraction input of the first subtracting unit (SU1).

10. Coder according to Claim 4, characterised in that the output of the first adder (AD1) is connected to the subtraction input (–) of the second subtracting unit (SU2) via a fourth multiplier (MU) which multiplies by the square of the prediction factor ($a^2$).

**Revendications**

1. Codeur pour une modulation différentielle impulsion-code (DIC) multidimensionnelle opérant à vitesse élevée, caractérisé par:
a) un dispositif de quantification (QE), en amont duquel est branché un circuit série constitué par des premier, second et troisième soustracteurs (SU1, SU2, SU3), des valeurs d'échantillonnage numérisées (si) étant envoyées au premier soustracteur (SU1) par l'entrée (1) du codeur,
b) une première boucle de calcul, qui relie, selon une boucle de reaction, la sortie (3) du dispositif de quantification (QE), auquel sont envoyées des valeurs MDIC quantifiées (Δsi, q), à l'entrée de soustraction (–) du troisième soustracteur (SU3) branché directement en amont du dispositif de quantification (QE), par l'intermédiaire d'un premier multiplicateur (M1), qui réalise une multiplication par un premier facteur prédictif constant (a),
c) une boucle interne de calcul, qui comporte un premier additionneur (AD), qui est raccordé à la sortie (3) du dispositif de quantification et dont la sortie est raccordée en retour à la seconde entrée du premier additionneur (AD1) par l'intermédiaire du circuit série formé d'un second registre (R2) et d'un second multiplicateur (M2) ainsi que par l'intermédiaire d'un second additionneur (AD2),
d) une seconde boucle de calcul, qui relie, selon une boucle de réaction, la sortie (3) du dispositif de quantification (QE) à l'entrée de soustraction (–) du second soustracteur (SU2) branché en amont du troisième soustracteur (SU3), par l'intermédiaire du premier additionneur (AD1), du second registre (R2) et par l'intermédiaire de deux multiplicateurs (M2, M3) réalisant respectivement des multiplications par le facteur prédictif (a), et
e) une troisième boucle de calcul, qui est raccordée par réaction, par l'intermédiaire du premier additionneur (AD1) et d'un dispositif de prédiction de lignes (PRL), qui délivre à sa sortie (6) une valeur estimée additionnelle

$$(\hat{S}zi)$$

à l'entrée de soustraction (–) du premier soustracteur (SU1), la sortie (6) du dispositif de prédiction de lignes (PRL) étant en outre reliée, par l'intermédiaire d'un registre ($R_{z+1}$) à la seconde entrée du second additionneur (AD2) dans la boucle interne de calcul.

2. Codeur suivant la revendication 1, caractérisé par le fait qu'un troisième registre (R3) est branché entre le premier soustracteur (SU1) et le second soustracteur (SU2) et que l'entrée de soustraction (–) du premier soustracteur (SU1) est reliée, non pas à la sortie (6), mais à une seconde sortie (6*) du dispositif de prédiction de ligne (PRL), auquel la valeur estimée additionnelle

$$(\hat{S}z_i)$$

est déjà appliquée plus tôt à la sortie (6) (figure 4).

3. Codeur suivant la revendication 1 ou 2, caractérisé par le fait que le dispositif de quantification (QE) contient un premier registre (R1) en aval duquel est branché un dispositif de quantification (Q), ou inversement.

4. Codeur suivant la revendication 1 ou 2, caractérisé par le fait qu'un quatrième registre (R4) est branché entre le second soustracteur (SU2) et le troisième soustracteur (SU3), que le second registre (R2) est branché directement en amont de la seconde entrée du premier additionneur (AD1), que la sortie du second additionneur est reliée à l'entrée du second registre (R2), et que le dispositif de quantification (QE) est un dispositif de quantification (Q) en aval duquel est branché un premier registre (R1) (figure 3).

5. Codeur suivant l'une des revendications précédentes, caractérisé par le fait qu'un limiteur (B) est branché en aval du premier additionneur (AD1).

6. Codeur suivant l'une des revendications précédentes, caractérisé par le fait qu'à la place des soustracteurs (SU1 à SU3), il est prévu des additionneurs, auxquels les valeurs de calcul devant être soustraites, sont envoyées, en étant multipliées par le facteur –1.

7. Codeur suivant l'une des revendications précédentes, caractérisé par le fait que seuls des facteurs prédictifs $a = 2^{-n}$ (n = 0, 1, 2, 3, ...) sont prévus et que les multiplicateurs (M) sont constitués par un câblage correspondant.

8. Codeur suivant la revendication 1, caractérisé par le fait que des circuits de retardement sont prévus à la place des registres (R).

9. Codeur suivant la revendication 1 ou 3, caractérisé par le fait qu'à la place du second soustracteur (SU2), il est prévu un troisième additionneur (AD3), dont les entrées sont reliées aux sorties du troisième multiplicateur (M3) et du dispositif de prédiction (PRL) et dont la sortie est reliée à l'entrée de soustraction du premier soustracteur (SU1).

10. Codeur suivant la revendication 4, caractérisé par le fait que la sortie du premier additionneur (AD1) est reliée, par l'intermédiaire d'un quatrième multiplicateur (MU) réalisant une multiplication par le carré du facteur prédictif ($a^2$), à l'entrée de soustraction (–) du second soustracteur (SU2).

# FIG 1

# FIG 2

# FIG 3

# FIG 4

## FIG 5

## FIG 6

FIG 7

FIG 8

# FIG 9

$\times$

B
$(\hat{=}sz_{i-1})$

C
$(\hat{=}sz_{i})$

D
$(\hat{=}sz_{i+1})$

$\times$

$\times$

A
$(\hat{=}s_{i-1})$

$s_{i}$

$\cdot$

# FIG 10

$$T_0 \qquad\qquad\qquad\qquad\qquad T_0$$

$$\longleftarrow \tau_{SU1} \longrightarrow$$

$$\mid \longleftarrow \tau_{SU2} \longrightarrow \mid$$

$$\longleftarrow \tau_{SU3} \longrightarrow \mid$$

$$\longleftarrow \tau_Q \longrightarrow$$

FIG 11

FIG 12